# EUROPÄISCHE PATENTANMELDUNG

(11) **EP 1 282 232 A1**
(43) Veröffentlichungstag der Anmeldung: **05.02.2003**
(21) Anmeldenummer: 02015448.0
(22) Anmeldetag: 11.07.2002
(51) Int. Cl.: H03K 17/95

(54) **Induktiver Näherungssensor**

(30) Priorität: 30.07.2001 DE 10137091
(71) Anmelder: Sick AG, 79183 Waldkirch, Breisgau (DE)
(72) Erfinder: Machul, Olaf, 79104 Freiburg (DE)
(74) Vertreter: Manitz, Finsterwald & Partner GbR

(57) **Zusammenfassung**

Die Erfindung betrifft einen induktiven Näherungssensor mit einem elektrischen Schwingkreis und einer hiermit gekoppelten elektrischen Energiequelle zum Ausgleich der Verluste im Schwingkreis. Die Energiequelle ist eingangsseitig voll differentiell mit dem Schwingkreis gekoppelt.

## Beschreibung

Die Erfindung betrifft einen induktiven Näherungssensor mit einem elektrischen Schwingkreis und einer hiermit gekoppelten elektrischen Energiequelle zum Ausgleich der Verluste im Schwingkreis.

Induktive Näherungssensoren finden Anwendung in der Automatisierungstechnik zur Bestimmung von Betriebszuständen in Automatisierungsanlagen, Fertigungssystemen (z. B. Schweißrobotern) und verfahrenstechnischen Anlagen. Näherungsschalter bewerkstelligen die Detektion der An- bzw. Abwesenheit von elektrisch leitfähigen Werkstücken oder Maschinenteilen. Ebenso sind Applikationen wie beispielsweise Drehzahlund Geschwindigkeitsmessungen an rotierenden oder translatorisch bewegten Teilen denkbar.

Induktive Näherungssensoren besitzen eingangsseitig einen verlustbehafteten Schwingkreis (Oszillator), dessen Verlustwiderstand beispielsweise durch Annäherung eines elektrisch leitfähigen Mediums verändert werden kann. Falls ein derartiges Ansprechelement in hinreichende Nähe des Schwingkreises gebracht wird, kann eine entsprechende Bedämpfung oder Entdämpfung des Schwingkreises verursacht und detektiert werden, um beispielsweise ein Schaltsignal auszulösen.

Durch Magnetisierungsverluste im Ferrit, den DC-Widerstand der Spule oder den Verlust durch die Bedämpfung durch das Ansprechelement verliert der Schwingkreis beständig Energie, die kompensiert werden muß, um ein unerwünschtes Abklingen der Schwingung zu verhindern.

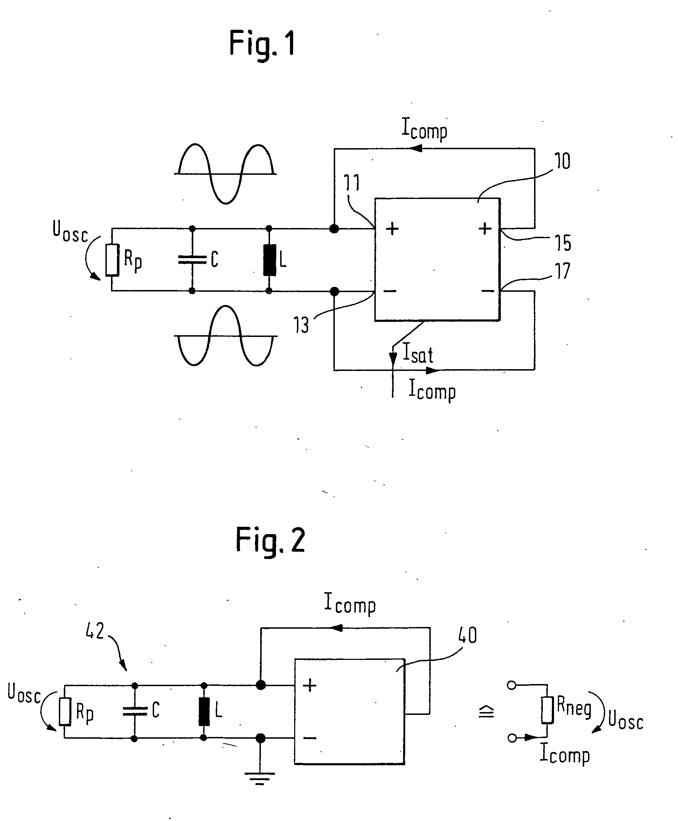

Hierfür ist eine Energiequelle 40 vorgesehen, durch die, zum Ausgleich der zuvor erwähnten Verluste, ein Kompensationsstrom I_{comp} gemäß Fig. 2 in den Schwingkreis 42 eingespeist werden kann.

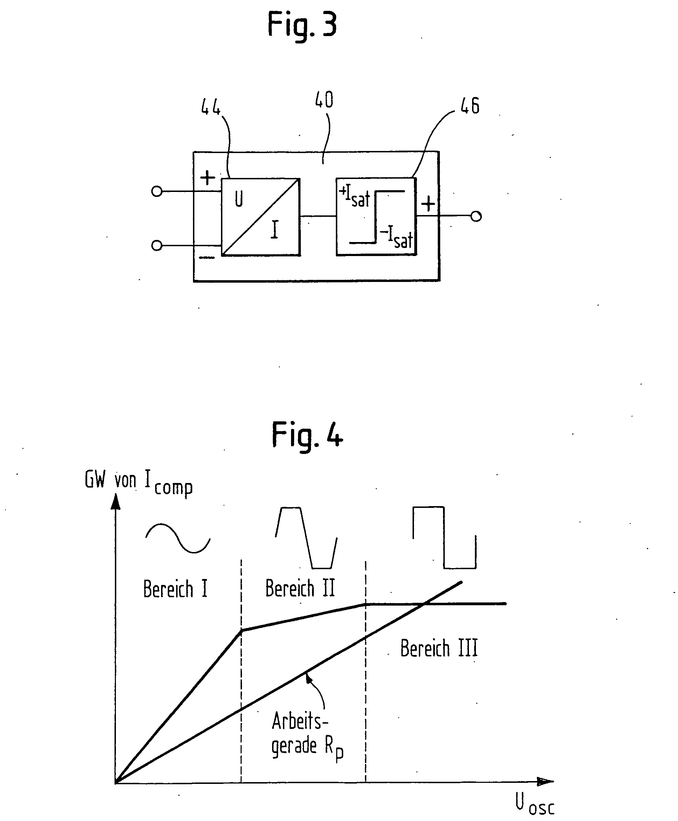

Die Energiequelle 40 ist beispielsweise aus einem U/I-Wandler 44 mit nachgeschalteter oder integrierter Strombegrenzung 46 gemäß Fig. 3 realisiert. Mit der Strombegrenzung 46 kann gezielt die Amplitude des Schwingkreises 42 eingestellt werden. Unterzieht man die Energiequelle 40 gemäß Fig. 2 einer Mitkopplung, so verhält sie sich wie ein negativer strombegrenzter Widerstand R_{neg}, da die über dem Schwingkreis abfallende Spannung U_{OSC} und der zurückgekoppelte Kompensationsstrom I_{comp} gemäß den Bezugspfeilkonventionen zueinander entgegengesetzt gerichtet sind. Der negative Widerstand R_{neg} ist für den Ausgleich der Verluste im Schwingkreis zuständig.

Derartige LC-Schwingreise 42 werden häufig im gesättigten Arbeitsbereich betrieben, damit Bauelemente-Toleranzen nur unwesentlich das Ansprechverhalten des Schwingkreises 42 beeinflussen. Dies ist im Bereich III der Fig. 4 dargestellt, in der der Maximalwert GW des Kompensationsstroms I_{comp} über dem Spannungsabfall U_{osc} am Schwingkreis eingezeichnet ist. In diesem Bereich III wird der Schwingkreis 42 mit rechteckförmigen Stromimpulsen angeregt. Durch den ausgewählten Arbeitsbereich wird unabhängig von der Schwingkreisamplitude stets der gleiche Strom in den Schwingkreis 42 eingekoppelt.

Die sich ergebende Schwingkreisamplitude U_{OSC} = (4/π) x Iₛₐₜ x Rₚ ist nur abhängig von dem Sättigungsstrom Iₛₐₜ und dem Verlustwiderstand Rₚ des Schwingkreises bei symmetrischem Ausgangsstrom (±Iₛₐₜ) der Energiequelle 40.

Nachteil dieses Arbeitsbereiches ist allerdings eine geringere Empfindlichkeit bei Bedämpfung des Schwingkreises. Elektrisch bzw. magnetisch eingekoppelte Störungen, die beim Einsatz des Näherungssensors im industriellen Umfeld auftreten können, überlagern dem kleinen Nutzsignal ein Störsignal, welches zu einer Beeinflussung des Schwingkreises bzw. zu einem unbeabsichtigten Schaltsignal führt.

Diese Störsignale können sowohl Gegen- als auch Gleichtaktcharakter besitzten. Die Beeinflussung des Schwingkreises kann letztendlich ein unerwünschtes Schaltsignal auslösen, ohne daß sich ein elektrisch leitfähiges Target im Schaltabstand des Näherungssensors befindet.

Es ist daher eine Aufgabe der Erfindung, einen induktiven Näherungssensor mit verringerter Störsignalanfälligkeit und verbessertem Ansprechverhalten zu schaffen.

Diese Aufgabe wird für einen Näherungssensor der eingangs erläuterten Art dadurch gelöst, daß die Energiequelle eingangsseitig voll differentiell mit dem Schwingkreis gekoppelt ist.

In diesem Zusammenhang heißt "voll differentiell", dass die beiden Eingänge der Energiequelle keinen Bezug zur Schaltungsmasse (negativstes Potential der Schaltung) oder einem sonstigen konstanten Potential besitzen. Lediglich der Gleichtaktanteil der beiden Eingänge wird auf Signalmasse (typischerweise halbe Betriebsspannung) geregelt, um den größtmöglichen Aussteuerbereich zu gewährleisten. Im Unterschied zu den herkömmlichen Energiequellen bei bekannten Näherungsschaltern wird keiner der mit dem LC-Schwingkreis gekoppelten Eingänge der Energiequelle auf Signal- oder Schaltungsmasse gelegt.

Als Eingänge der Energiequelle sind diejenigen Anschlüsse der Energiequelle anzusehen, über die zur Bestimmung der Amplitude des Schwingkreises die am Schwingkreis abfallende Spannung abgegriffen wird.

Aufgrund der erfindungsgemäßen Kopplung von LC-Schwingkreis und Energiequelle besitzt der Näherungssensor den Vorteil eines verdoppelten Signalhubs. Dadurch wird der eingangs erwähnte Nachteil einer geringeren Empfindlichkeit aufgrund des gewählten Arbeitsbereiches (siehe Fig. 4, Bereich III) kompensiert bei weiterhin erhaltenem Vorteil einer geringen Empfindlichkeit des Ansprechverhaltens des Schwingkreises gegenüber vorhandenen Bauelemente-Toleranzen.

Die erfindungsgemäße Kopplung von Schwingkreis und Energiequelle bewirkt zudem eine verbesserte Störempfindlichkeit durch ein höheres Signal/Rausch-Leistungsverhältnis.

Der erfindungsgemäße Näherungssensor ermöglicht darüberhinaus größere Reichweiten gegenüber bekannten Näherungssensoren aufgrund des verdoppelten Signalhubs.

Letztendlich verarbeitet der erfindungsgemäße Näherungssensor nur Gegentaktanteile der Schwingkreisspannung und unterdrückt Gleichtaktanteile. Gleichtaktanteile in der Schwingkreisspannung können zum einen durch induktive Einkopplungen in den LC-Schwingkreis, beispielsweise verursacht durch in der Nähe befindliche Schweißgeräte, bzw. durch kapazitive Einkopplungen in die Verbindungsleitungen zwischen Schwingkreis und Energiequelle verursacht werden. Diese Gleichtaktstörungen führen beim herkömmlichen Näherungsensor zu einer Beeinflussung des Schwingkreises und letztendlich zu einem Fehlschalten.

Es ist bevorzugt, wenn die Ausgänge der Energiequelle mit den Eingängen mitgekoppelt sind zur Bereitstellung des Kompensationsstromes.

Zu der Erfindung ist ferner anzumerken, daß jede Art einer Energiequelle zur Kompensation der Energieverluste innerhalb des Schwingkreises verwendet werden kann. Insbesondere kann die Energiequelle einen Spannungs-/Strom-Wandler, beispielsweise einen Transkonduktanzverstärker aufweisen.

In einer bevorzugten Ausführungsform der Erfindung ist die von der Energiequelle in den Schwingkreis einspeisbare Kompensationsenergie, insbesondere der elektrische Kompensationsstrom, durch eine Begrenzungsschaltung begrenzt. Auf diese Weise kann die Amplitude des Schwingkreises entsprechend begrenzt werden. Vorzugsweise ist diese Begrenzung des Kompensationsstroms bzw. der Amplitude der Oszillation einstellbar.

Weiterhin ist es bevorzugt, wenn die Energiequelle in CMOS-Bauweise gefertigt ist.

Weitere Ausführungsformen der Erfindung sind in den Unteransprüchen genannt.

Die Erfindung wird nachfolgend beispielhaft unter Bezugnahme auf die Zeichnungen erläutert; in diesen zeigen:
- Fig. 1: ein Blockschaltbild eines Schwingkreises und einer hiermit erfindungsgemäß gekoppelten Energiequelle,
- Fig. 2: ein Blockschaltbild eines Schwingkreises in und einer hiermit nach dem Stand der Technik gekoppelten Energiequelle,
- Fig. 3: eine Ausführungsform der Energiequelle nach dem Stand der Technik, und
- Fig. 4: eine Darstellung der Arbeitsbereiche eines Schwingkreises.

Fig. 1 zeigt einen durch einen Kondensator C und eine Spule L gebildeten Schwingkreis mit einem Verlustwiderstand Rₚ. Über diesem Schwingkreis fällt die Spannung U_{OSC} ab.

Eine Energiequelle 10, die als Transkonduktanzverstärker (operational transconductivity amplifier, OTA) ausgebildet sein kann, ist mit dem Schwingkreis gekoppelt.. Diese Kopplung ist voll differentiell ausgebildet, d. h. ein positiver Eingang 11 und ein negativer Eingang 13 der Energiequelle 10 sind mit dem Schwingkreis verbunden, ohne daß das Potential einer dieser beiden Anschlüsse auf einen konstanten Wert festgelegt ist. Über diese beiden Eingänge 11, 13 erfaßt die Energiequelle 10 Gegentaktsignale des Schwingkreises, während Störsignale, die sich aufgrund der voll differentiellen Kopplung als Gleichtaktsignale äußern, unterdrückt werden.

Zum Ausgleich der Dämpfungsverluste innerhalb des Stromkreises werden über Ausgänge 15, 17 der Energiequelle 10 Kompensationsströme I_{comp} dem Schwingkreis zugeführt, und zwar in Abhängigkeit von dem an den Eingängen 11, 13 anliegenden Gegentaktsignal (Resonanzschwingung).

Wie in Fig. 1 für den Sättigungsstrom Iₛₐₜ der Energiequelle 10 angedeutet, ist die Begrenzung der Kompensationsströme I_{comp} einstellbar, um dadurch die maximale Amplitude der Schwingung innerhalb des Schwingkreises zu begrenzen.

Die Schaltung gemäß Fig. 1 bildet einen Teil eines induktiven Näherungssensors, der ferner eine mit dem Schwingkreis gekoppelte, nicht dargestellte Auswerteschaltung aufweist. Durch diese wird auf bekannte Weise eine Annäherung des Ansprechelements erfaßt, um beispielsweise - bei der Ausbildung des Sensors als Näherungsschalter - ein Schaltsignal auszulösen.

### Bezugszeichenliste

- 10: Energiequelle
- 11, 13: Eingänge der Energiequelle
- 15, 17: Ausgänge der Energiequelle
- 40: Energiequelle
- 42: Schwingkreis
- 44: Spannungs-/Strom-Wandler
- 46: Strombegrenzung

- L: Spule
- C: Kondensator
- Rₚ: Verlustwiderstand
- I_{comp}: Kompensationsstrom
- Iₛₐₜ: Sättigungsstrom
- R_{neg}: negativer Widersstand
- U_{OSC}: Spannungsabfall

## Patentansprüche

1. Induktiver Näherungssensor mit einem elektrischen Schwingkreis (L, C, Rp) und einer hiermit gekoppelten elektrischen Energiequelle (10) zum Ausgleich der Verluste im Schwingkreis,
**dadurch gekennzeichnet,**
**daß** die Energiequelle (10) voll differentiell mit dem Schwingkreis (L, C, Rₚ) gekoppelt ist.

2. Näherungssensor nach Anspruch 1,
**dadurch gekennzeichnet,**
**daß** keiner der mit dem Schwingkreis (L, C, Rₚ) gekoppelten Eingänge der Energiequelle (10) auf konstantem Potential liegt.

3. Näherungssensor nach einem der vorherigen Ansprüche,
**dadurch gekennzeichnet,**
**daß** die Ausgänge (15, 17) mit den Eingängen (11, 13) der Energiequelle (10) mitgekoppelt sind.

4. Näherungssensor nach einem der vorherigen Ansprüche,
**dadurch gekennzeichnet,**
**daß** die Energiequelle (10) einen Spannungs-/Strom-Wandler aufweist.

5. Näherungssensor nach Anspruch 4,
**dadurch gekennzeichnet,**
**daß** der Spannungs-/Strom-Wandler als Transkonduktanzverstärker ausgebildet ist.

6. Näherungssensor nach einem der vorherigen Ansprüche,
**dadurch gekennzeichnet,**
**daß** die Energiequelle strombegrenzbar ist.

7. Näherungssensor nach Anspruch 6,
**dadurch gekennzeichnet,**
**daß** die Strombegrenzung der Energiequelle (10) einstellbar ist.

8. Näherungssensor nach einem der vorherigen Ansprüche,
**dadurch gekennzeichnet,**
**daß** die Energiequelle (10) in CMOS-Bauweise ausgebildet ist.

9. Näherungssensor nach einem der vorherigen Ansprüche,
**dadurch gekennzeichnet,**
**daß** eine Auswerteschaltung zur Erfassung von Gegentaktsignalen vorgesehen ist, die mit dem Schwingkreis gekoppelt ist.
